# EUROPEAN PATENT APPLICATION

(11) **EP 3 699 249 A1**
(43) Date of publication of application: **26.08.2020**
(21) Application number: 19741090.5
(22) Date of filing: 11.01.2019
(51) Int. Cl.: C09J 7/30, C09J 133/08, C09J 133/10, C09J 7/22, H01L 21/02

(54) **BACK GRINDING TAPE**

(30) Priority: 22.01.2018 KR 20180007963; 08.01.2019 KR 20190002459
(71) Applicant: LG CHEM, LTD., Yeongdeungpo-gu, Seoul 07336 (KR)
(72) Inventor: YOON, Mi Seon, Daejeon 34122 (KR); KIM, Sera, Daejeon 34122 (KR); LEE, Kwang Joo, Daejeon 34122 (KR); YEON, Bora, Daejeon 34122 (KR); PARK, Sung Chan, Daejeon 34122 (KR); KIM, Eun Yeong, Daejeon 34122 (KR)
(74) Representative: Goddar, Heinz J.
(86) International application number: PCT/KR2019/000486
(87) International publication number: WO 2019/143076

(57) **Abstract**

The present invention relates to a back grinding tape including a polymer substrate and an adhesive layer, wherein the adhesive layer includes a (meth)acrylate resin containing 30 to 60 % by weight of a repeating unit derived from a monomer or an oligomer having a glass transition temperature of 0 °C or higher, and wherein the adhesive layer has a glass transition temperature of -20 °C to 10 °C, and a method of grinding wafers using the back grinding tape.

## Description

### [TECHNICAL FIELD]

### CROSS-REFERENCE TO RELATED APPLICATION(S)

This application claims the benefits of filing dates of Korean Patent Application No. 10-2018-0007963 filed with the Korean Intellectual Property Office on January 22, 2018 and Korean Patent Application No. 10-2019-0002459 filed with the Korean Intellectual Property Office on January 8, 2019, the entire contents of which are incorporated herein by reference.

The present invention relates to a back grinding tape.

### [BACKGROUND ART]

Recently, the tendency toward miniaturization, high functionalization, and capacity enlargement of electronic equipment has been expanding, and the need for densification and high integration of semiconductor packages has rapidly increased.

Reflecting this, the size of the semiconductor chips become larger and at the same time the thickness of the chip becomes thinner, and the degree of integration of the circuit increases. However, the modulus of the chip itself is reduced, thereby causing problems in the manufacturing process or reliability of the final product.

To meet such request for enlargement and thinning of semiconductor, a grinding (back grinding) process for facilitating the assembly is essentially performed by grinding the back surface of the wafer with a polishing wheel composed of fine diamond particles to reduce the thickness of the chip. However, during the grinding process, damage to the wafer such as contamination or cracking due to a large amount of silicon residue (dust) and particles frequently occur.

Accordingly, the role of the adhesive film or the back grinding tape for protecting the surface of the semiconductor wafer is further emphasized.

As a semiconductor device is further miniaturized and thinned, a process of grinding a wafer to a thinner thickness than the conventional one is required. Accordingly, when the adhesive film used in the step of grinding the wafer to a thickness of about 100 *µ*m is applied to the process of grinding the wafer to a thickness of about 50 *µ*m, creep deformation of the adhesive tape is high, which may cause problems such as misalignment of a die after grinding.

### [DETAILED DESCRIPTION OF THE INVENTION]

### [TECHNICAL PROBLEM]

An object of the present invention is intended to provide a back grinding tape capable of being easily applied to a process of grinding a wafer having a thin thickness, and of preventing problems such as misalignment of a die after grinding by maintaining creep deformation of the adhesive tape at a low level.

Another object of the present invention is intended to provide a method of grinding wafers using the back grinding tape.

### [TECHNICAL SOLUTION]

In order to achieve the above-mentioned objects, the present invention provides a back grinding tape including: a polymer substrate; and an adhesive layer, wherein the adhesive layer includes a (meth)acrylate resin containing 30 to 60 % by weight of a repeating unit derived from a monomer or oligomer having a glass transition temperature of 0 °C or higher, and wherein the adhesive layer has a glass transition temperature of -20 °C to 10 °C.

The present invention also provides a method of grinding wafers using the back grinding tape.

Hereinafter, the back grinding tape and the method of grinding wafers according to a specific embodiment of the present invention will be described in more detail.

As used herein, the term "(meth)acrylate" is intended to cover both acrylate and methacrylate.

As described above, according to one embodiment of the invention, a back grinding tape including a polymer substrate, and an adhesive layer, can be provided, wherein the adhesive layer includes a (meth)acrylate resin containing 30 to 60 % by weight of a repeating unit derived from a monomer or oligomer having a glass transition temperature of 0 °C or higher, and wherein the adhesive layer has a glass transition temperature of -20 °C to 10 °C.

The present inventors conducted studies on the back grinding tape including a polymer substrate and an adhesive layer, and found through experiments that when the adhesive layer includes a (meth)acrylate resin containing 30 to 60 % by weight of a repeating unit derived from a monomer or oligomer having a glass transition temperature of 0 °C or higher, it has a glass transition temperature of -20 °C to 10 °C, it can be easily applied to a process of grinding a wafer having a thin thickness of about 50 *µ*m, and can prevent problems such as misalignment of the die after grinding by maintaining the creep deformation of the adhesive tape at a low level, thereby completing the present invention.

More specifically, as the adhesive layer has a glass transition temperature of - 20 °C to 10 °C, the creep strain may be 10 to 30 % when applying a force of 20,000 Pa at 90 °C. The condition of applying a force of 20,000 Pa at 90°C can correspond to the horizontal force received by the grinding wheel during back grinding in the back grinding process. As the adhesive layer has creep deformation of 10 to 30 % under the above conditions, it is possible to prevent the die from being misaligned after the back grinding process.

If the creep deformation is less than 10 % when a force of 20,000 Pa is applied to the adhesive layer at 90 °C, the modulus of the adhesive layer is high and thus the adhesion stability is lowered, so it can be detached during the process. If the creep deformation is more than 30 % when a force of 20,000 Pa is applied to the adhesive layer at 90°C, the modulus of the adhesive layer is low, so the die may be misaligned or adhesive residues may be formed on the semiconductor circuit surface.

The creep deformation means a deformation of a material with time when a certain force is applied to a predetermined material for a long time, and as time passes, the degree of deformation also tends to increase.

The back grinding tape of the embodiment may exhibit a low level of creep deformation rate by including the aforementioned adhesive layer. Consequently, even when a force is applied to the semiconductor wafer to which the back-grinding tape is attached in the back grinding process, deformation of the adhesive layer may not be large, and the occurrence of die-shift due to the force applied to the wafer during the back grinding process can be suppressed.

As the adhesive layer includes a (meth)acrylate resin containing 30 to 60 % by weight of a repeating unit derived from a monomer or oligomer having a glass transition temperature of 0 °C or higher, it can have a glass transition temperature of -20 °C to 10 °C.

More specifically, the monomer or oligomer having a glass transition temperature of 0 °C or higher may have a glass transition temperature of 0 °C to 100 °C.

Specific examples of the monomer or oligomer having a glass transition temperature of 0 °C or higher include at least one compound selected from the group consisting of methyl acrylate, isobornyl (meth)acrylate, and hydroxycyclohexyl (meth)acrylate.

In addition, the (meth)acrylate resin may further include a (meth)acrylate-based repeating unit having an alkyl group having 2 to 12 carbon atoms or a (meth)acrylate-based repeating unit containing a crosslinkable functional group, together with a repeating unit derived from the monomer or oligomer having a glass transition temperature of 0 °C or higher.

Specifically, the (meth)acrylate resin may include 30 to 60 % by weight of a repeating unit derived from a monomer or oligomer having a glass transition temperature of 0 °C or higher, and 40 to 70 % by weight of a (meth)acrylate-based repeating unit having an alkyl group having 2 to 12 carbon atoms or a (meth)acrylate-based repeating unit containing a crosslinkable functional group.

The (meth)acrylate-based repeating unit having an alkyl group having 2 to 12 carbon atoms may be a repeating unit derived from at least one monomer or oligomer selected from the group consisting of pentyl(meth)acrylate, n-butyl(meth)acrylate, ethyl(meth)acrylate, hexyl(meth)acrylate, n-octyl(meth)acrylate, isooctyl(meth)acrylate, 2-ethylhexyl(meth)acrylate, dodecyl(meth)acrylate, decyl(meth)acrylate, and the like.

Specific examples of the (meth)acrylate-based repeating unit containing a crosslinkable functional group include a (meth)acrylate-based repeating unit containing a hydroxyl group, a carboxyl group, a functional group containing nitrogen, and the like, and the (meth)acrylate-based repeating unit containing a crosslinkable functional group may be derived from a (meth)acrylate-based monomer containing the crosslinkable functional group.

In this case, examples of the hydroxyl group-containing (meth)acrylate-based monomer may include 2-hydroxyethyl (meth)acrylate, 2-hydroxypropyl (meth)acrylate, and the like. Examples of the carboxyl group-containing (meth)acrylate-based monomer may include (meth)acrylic acid and the like. Examples of the (meth)acrylate monomer containing a nitrogen-containing functional group include (meth)acrylonitrile, N-vinylpyrrolidone, N-vinylcaprolactam, and the like, but are not limited thereto.

The (meth)acrylate resin may have a weight average molecular weight of 100,000 to 1,500,000, preferably 200,000 to 1,000,000.

When the weight average molecular weight of the (meth)acrylate resin is less than 100,000, the coating property or the cohesive force is lowered, and residues may remain on the adherend during peeling or a breakdown phenomenon of the adhesive may occur.

Further, when the weight average molecular weight of the (meth)acrylate resin is more than 1,500,000, it is necessary to add extra dilution solvent due to high viscosity, and the coating property can be deteriorated.

Meanwhile, the adhesive layer may include an ultraviolet curable adhesive or a heat curable adhesive.

When an ultraviolet curable adhesive is used, ultraviolet rays are irradiated to increase the cohesive force and the glass transition temperature of the adhesive, thus lowering the adhesive strength. In the case of a heat curable adhesive, a temperature is added to lower the adhesive strength.

The (meth)acrylate-based resin may further include a low molecular weight compound containing a carbon-carbon double bond of vinyl acetate, styrene, or acrylonitrile.

The adhesive layer may further include a polyfunctional (meth)acrylate compound.

The polyfunctional (meth)acrylate compound has a weight average molecular weight of 100 to 100,000, and it may include at least one selected from the group consisting of a polyfunctional urethane (meth)acrylate and a polyfunctional (meth)acrylate monomer or oligomer.

The weight average molecular weight is a weight average molecular weight in terms of polystyrene measured by a GPC method.

The content of the polyfunctional (meth)acrylate compound may be 5 parts by weight to 400 parts by weight, preferably 10 parts by weight to 200 parts by weight, based on 100 parts by weight of the (meth)acrylate resin.

When the content of the polyfunctional (meth)acrylate compound is less than 5 parts by weight, the adhesive strength after curing may not be sufficiently decreased. When the content of the polyfunctional (meth)acrylate compound exceeds 400 parts by weight, the cohesive force of the adhesive before ultraviolet irradiation may be insufficient.

The adhesive layer may further include a photoinitiator.

The type of the photoinitiator is not particularly limited, and common initiators known in the art can be used. The content thereof may be 0.05 parts by weight to 20 parts by weight based on 100 parts by weight of the polyfunctional (meth)acrylate compound. When the content of the photoinitiator is less than 0.05 parts by weight, the curing reaction by ultraviolet irradiation may be insufficient.

When the content of the photoinitiator exceeds 20 parts by weight, in the curing process, the crosslinking reaction occurs in short units or an unreacted ultraviolet curable compound is generated, which may cause residues on the surface of the adherend, or the peeling force after curing may be excessively low.

The adhesive layer may include at least one crosslinking agent selected from the group consisting of an isocyanate-based compound, an aziridine-based compound, an epoxy-based compound, and a metal chelate-based compound.

The crosslinking agent may be contained in an amount of 2 to 40 parts by weight, preferably 2 to 20 parts by weight, based on 100 parts by weight of the polyfunctional (meth)acrylate compound.

When the content of the crosslinking agent is less than 2 parts by weight, the cohesive force of the adhesive may be insufficient, and when the content exceeds 20 parts by weight, adhesion before ultraviolet irradiation may be insufficient.

The adhesive layer may further include at least one tackifier selected from the group consisting of a rosin resin, a terpene resin, a phenol resin, a styrene resin, an aliphatic petroleum resin, an aromatic petroleum resin, and an aliphatic and aromatic copolymerized petroleum resin.

The method of coating and drying the adhesive composition for forming the adhesive layer is not particularly limited, and for example, a method in which a composition containing each of the above components is used as it is or diluted with an appropriate organic solvent, and coated by a known means such as a comma coater, a gravure coater, a die coater, or a reverse coater and then the solvent is dried at a temperature of 60 °C to 200 °C for 10 seconds to 30 minutes can be used.

Further, in the above process, an aging step for progressing a sufficient crosslinking reaction of the adhesive may be additionally performed.

The thickness of the adhesive layer is not particularly limited, but may be in the range of, for example, 5 *µ*m to 300 *µ*m, or 10 *µ*m to 100 *µ*m.

On the other hand, the polymer substrate is not particularly limited, and examples of the polymer substrate include at least one polymer resin selected from the group of polyurethane, polyethylene terephthalate, low-density polyethylene, linear polyethylene, medium density polyethylene, high density polyethylene, ultra low density polyethylene, a random copolymer of polypropylene, a block copolymer of polypropylene, homopolypropylene, polymethylpentene, an ethylene-vinyl acetate copolymer, an ethylene-methacrylic acid copolymer, an ethylene-methylmethacrylate copolymer, an ethylene-ionomer copolymer, an ethylene-vinyl alcohol copolymer, polybutene, and a styrene copolymer,

The thickness of the polymer substrate is not particularly limited, and for example, it may be in a range of 10 *µ*m to 500 *µ*m.

On the other hand, according to another embodiment of the invention, a method of grinding a wafer using the aforementioned back grinding tape can be provided.

A step of grinding semiconductor wafers can be performed in a state where the back grinding tape is adhered to one surface of the semiconductor wafer. After the grinding step, the back grinding tape may be irradiated with ultraviolet rays or subjected to heat treatment and the like to peel off the tape.

In the step of grinding semiconductor wafers, the method of using the back grinding tape is not particularly limited, and for example, after attaching the back grinding tape to a half-cut circuit surface at room temperature to a thickness of 50 *µ*m, the surface to which the grinding tape is attached can be fixed to a vacuum table, and thereby the back surface of the circuit surface can be ground.

Then, the back grinding tape may be removed through the method of irradiating the back grinding tape on the ground wafer with UV A at 500 of mJ/cm² or more.

### [ADVANTAGEOUS EFFECTS]

According to the present invention, a back grinding tape capable of being easily applied in a process of grinding wafers having a thin thickness, and of preventing problems such as misalignment of a die after grinding by maintaining creep deformation of the adhesive tape at a low level, and a method of grinding a wafer using the back grinding tape, can be provided.

### [DETAILED DESCRIPTION OF THE EMBODIMENTS]

The present invention will be described in more detail by way of examples shown below.

However, these examples are provided for illustrative purposes only and the scope of the invention is not intended to be limited to or by these examples.

### [Preparation Examples: Preparation of (meth)acrylate resin]

### Preparation Example 1

A mixture of monomers consisting of 27 g of 2-ethylhexyl acrylate (2-EHA), 48 g of methyl acrylate (MA, glass transition temperature of 86 °C), and 25 g of hydroxyethyl acrylate (HEA) were added to a reactor equipped with a cooling system so as to achieve reflux of nitrogen gas and ease of temperature control.

Then, based on 100 parts by weight of the monomer mixture, n-DDM at 400 ppm as a chain transfer agent (CTA) and 100 parts by weight of ethyl acetate (EAc) as a solvent were added thereto, and sufficiently mixed with each other at 30 °C for 30 minutes or more while injecting nitrogen to remove oxygen from the reactor.

Then, the temperature was increased to and maintained at 50 °C, and V-70 [2,2'-azobis(4-methoxy-2,4-dimethylvaleronitrile)] at 300 ppm as a reaction initiator was added thereto to thereby initiate the reaction, followed by polymerization for 24 hours, to prepare a primary reaction material.

24.6 parts by weight of 2-methacroyloxyethyl isocyanate (MOI) (70 mol% based on HEA in the primary reaction material) and 1 wt% of a catalyst (dibutyl tin dilaurate: DBTDL) based on the MOI were mixed in the primary reaction material, and then allowed to react at 40 °C for 24 hours, whereby an ultraviolet curing group was introduced into a branched chain of the polymer in the primary reaction material. Thereby, a (meth)acrylate-based polymer resin (weight average molecular weight: about 900,000 g/mol) was prepared.

### Preparation Example 2

A (meth)acrylate-based polymer resin (weight average molecular weight: about 900,000 g/mol) was prepared in the same manner as in Preparation Example 1, except that a mixture of monomers consisting of 27 g of 2-ethylhexyl acrylate (2-EHA) and 25 g of hydroxyethyl acrylate (HEA) was added.

### [Examples and Comparative Examples: Preparation of back grinding tape]

### Example 1

7 g of a TDI-based isocyanate curing agent and 3 g of a photoinitiator (Irgacure 184) were mixed with 100 g of the (meth)acrylate-based polymer resin of Preparation Example 1 to prepare an adhesive composition.

The adhesive composition was coated onto a release-treated PET having a thickness of 38 um, and dried at 110 °C for 3 minutes to form an adhesive layer (glass transition temperature Tg -17 °C) having a thickness of 20 um.

### Comparative Example 1

7 g of a TDI-based isocyanate curing agent, and 3 g of a photoinitiator (Irgacure 184) were mixed with 100 g of the (meth)acrylate-based polymer resin of Preparation Example 2 to prepare an adhesive composition.

The adhesive composition was coated onto a release-treated PET having a thickness of 38 um, and dried at 110 °C for 3 minutes to form an adhesive layer (glass transition temperature Tg -55 °C) having a thickness of 20 um.

### [Experimental Example]

### Experimental Example 1: Measurement of Creep Deformation

Creep deformation was measured by applying a force of 20,000 Pa to the adhesive layer of the examples and comparative examples at 90 °C.

More specifically, after the adhesive layers of the examples and comparative examples were formed to a thickness of 1 mm or more, they were measured using ARES-G2 equipment (TA Instruments).

Using an 8 mm stainless steel plate, a force of 20,000 Pa was applied at 90 °C for 100 seconds to measure the creep deformation of the adhesive layer.

### Experimental Example 2: Grinding Test of Wafer

Using each of the back grinding tapes using the adhesive of the examples and comparative examples, a back grinding tape was attached to the semiconductor circuit surface where a half cut was performed to a thickness of 50 µm, and a 780 µm wafer was subjected to back surface grinding to a thickness of 50 µm.

The back grinding tape was removed by irradiating with UV A at 500 mJ/cm², and the alignments of dies before and after grinding were compared.

**[Table 1]**

| | Example 1 | Comparative Example 1 |
|---|---|---|
| Creep measurement (%) | 20 | 100 |
| Grinding test of wafer | Maintain alignment of die before and after grinding | Misalignment of die occurs |

As can be seen in Table 1 above, it was confirmed that when a force of 20,000 Pa was applied to the adhesive layer of the back grinding tape of Example 1 at 90 °C, the creep deformation was 20 % and alignment of the die before and after grinding was not changed.

On the other hand, it was confirmed that when a force of 20,000 Pa was applied to the adhesive layer of the back grinding tape of Comparative Example 1 at 90 °C, the creep deformation was 100 %, and misalignment of the die from before to after grinding occurred.

## Claims

1. A back grinding tape including a polymer substrate and an adhesive layer,
wherein the adhesive layer includes a (meth)acrylate resin containing 30 to 60 % by weight of a repeating unit derived from a monomer or oligomer having a glass transition temperature of 0 °C or higher, and
wherein the adhesive layer has a glass transition temperature of -20 °C to 10 °C.

2. The back grinding tape of claim 1, wherein
the monomer or oligomer having a glass transition temperature of 0 °C or higher includes at least one compound selected from the group consisting of methyl acrylate, isobornyl (meth)acrylate, and hydroxycyclohexyl (meth)acrylate.

3. The back grinding tape of claim 1, wherein
the (meth)acrylate resin further includes a (meth)acrylate-based repeating unit having an alkyl group having 2 to 12 carbon atoms or a (meth)acrylate-based repeating unit containing a crosslinkable functional group, together with a repeating unit derived from the monomer or oligomer having a glass transition temperature of 0 °C or higher.

4. The back grinding tape of claim 3, wherein
the (meth)acrylate resin includes 30 to 60 % by weight of a repeating unit derived from a monomer or oligomer having a glass transition temperature of 0 °C or higher, and
40 to 70 % by weight of a (meth)acrylate-based repeating unit having an alkyl group having 2 to 12 carbon atoms or a (meth)acrylate-based repeating unit containing a crosslinkable functional group.

5. The back grinding tape of claim 1, wherein
creep deformation is 10 to 30 % when a force of 20,000 Pa is applied to the adhesive layer at 90 °C.

6. The back grinding tape of claim 1, wherein
the adhesive layer further includes a polyfunctional (meth)acrylate compound.

7. The back grinding tape of claim 6, wherein
the polyfunctional (meth)acrylate compound has a weight average molecular weight of 100 to 100,000, and includes at least one selected from the group consisting of a polyfunctional urethane (meth)acrylate and a polyfunctional (meth)acrylate monomer or oligomer.

8. The back grinding tape of claim 1, wherein
the adhesive layer includes a photoinitiator,
at least one crosslinking agent selected from the group consisting of an isocyanate-based compound, an aziridine-based compound, an epoxy-based compound, and a metal chelate-based compound,
or
at least one tackifier selected from the group consisting of a rosin resin, a terpene resin, a phenol resin, a styrene resin, an aliphatic petroleum resin, an aromatic petroleum resin, and an aliphatic and aromatic copolymerized petroleum resin.

9. The back grinding tape of claim 1, wherein
the polymer substrate includes at least one polymer resin selected from the group consisting of low-density polyethylene, linear polyethylene, medium density polyethylene, high density polyethylene, ultra low density polyethylene, a random copolymer of polypropylene, a block copolymer of polypropylene, homopolypropylene, polymethylpentene, an ethylene-vinyl acetate copolymer, an ethylene-methacrylic acid copolymer, an ethylene-methylmethacrylate copolymer, an ethylene-ionomer copolymer, an ethylene-vinyl alcohol copolymer, polybutene, and a styrene copolymer,

10. A method of grinding wafers using the back grinding tape of claim 1.
